# FASCICULE DE BREVET EUROPEEN

(11) **EP 4 075 408 B1**
(45) Date de publication et mention de la délivrance du brevet: **28.10.2026**
(21) Numéro de dépôt: 22164748.0
(22) Date de dépôt: 28.03.2022
(51) Int. Cl.: G06N 20/10, G06N 20/20, G06N 5/01, G06N 3/0499, G08G 1/01, G06N 3/08, G08G 1/02, G08G 1/04, G06N 3/09

(54) **PROCÉDÉ DE DÉTERMINATION DE LA QUANTITÉ D'ÉMISSION POLLUANTES ÉMISES PAR UN VÉHICULE SUR UN BRIN D'UN RÉSEAU ROUTIER**
VERFAHREN ZUR BESTIMMUNG DER MENGE DER VON EINEM FAHRZEUG AUF EINEM STRASSENABSCHNITT AUSGESTOSSENEN SCHADSTOFFEMISSIONEN
METHOD FOR DETERMINING THE AMOUNT OF POLLUTANT EMISSIONS EMITTED BY A VEHICLE ON A SECTION OF A ROAD NETWORK

(30) Priorité: 14.04.2021 FR 2103844
(43) Date de publication de la demande: 19.10.2022
(73) Titulaire: IFP Energies nouvelles, 92500 Rueil-Malmaison (FR)
(72) Inventeur: DE NUNZIO, Giovanni, 92852 RUEIL-MALMAISON CEDEX (FR); LARAKI, Mohamed, 92852 RUEIL-MALMAISON CEDEX (FR); OTHMAN, Bassel, 92852 RUEIL-MALMAISON CEDEX (FR); THIBAULT, Laurent, 92852 RUEIL-MALMAISON CEDEX (FR)
(74) Mandataire: IFP Energies nouvelles

(56) Documents cités:
- CN-A- 109 086 246
- FR-A1- 3 096 822
- FR-A1- 3 096 822
- US-A1- 2019 102 960
- US-A1- 2019 102 960
- US-A1- 2020 355 108
- US-A1- 2020 355 108

## Description

### Domaine technique

La présente invention concerne le domaine de la détermination des émissions polluantes émises par au moins un véhicule sur un réseau routier.

Selon l'Organisation Mondiale de la Santé (OMS), environ 18000 décès par jour sont attribuables à une mauvaise qualité de l'air, ce qui fait monter l'estimation à environ 6,5 millions de décès par an. La pollution atmosphérique représente également un fort enjeu financier : une commission d'enquête sénatoriale estime que le coût total de la pollution de l'air s'établit entre 68 et 97 milliards d'euros par an pour la France, dans une évaluation, rendue en juillet 2015, intégrant à la fois les dommages sanitaires de la pollution, mais également ses conséquences sur les bâtiments, les écosystèmes et l'agriculture. Le secteur des transports représente toujours l'une des sources les plus importantes de polluants, malgré les nombreuses mesures mises en place par les pouvoirs publics et les avancées technologiques dans le domaine. Les transports, tous modes confondus, sont responsables d'environ 50% des émissions globales d'oxydes d'azote (NOₓ) et environ 10% des émissions de particules PM2,5 (c'est-à-dire des particules d'un diamètre inférieur à 2.5 microns). Le transport routier seul représente une part considérable de cet apport dû aux transports, avec 58% des émissions de NOₓ et 73% des émissions de particules PM2,5. Ces émissions sont dues principalement à trois facteurs : les émissions à l'échappement, les émissions d'abrasion, les émissions d'évaporation. Si les poids lourds sont les principaux émetteurs de polluants, ce sont les véhicules particuliers, plus représentés dans les zones urbaines fortement peuplées, qui ont l'impact le plus élevé sur l'exposition des citoyens à une mauvaise qualité de l'air.

Les mesures mises en place au niveau local pour gérer l'utilisation des transports (comme une meilleure planification des transports et les mesures pour inciter le transfert modal, c'est-à-dire le changement de mode de transport), ainsi que le progressif renouvellement du parc automobile, ont contribué à limiter les émissions de gaz à l'échappement du transport routier dans les villes et les agglomérations urbaines. En effet, dans le monde, l'activité liée au transport routier a augmenté d'un quart au cours de la dernière décennie, alors que les émissions de NOₓ ont augmenté de 5% et les émissions de particules ont diminué de 6%. Malgré ces améliorations, les niveaux de pollution dépassent encore les seuils fixés par l'OMS dans de nombreuses villes.

Pour améliorer significativement la qualité de l'air sur leur territoire, les collectivités françaises en milieu urbain se doivent d'agir pour réduire les émissions liées au transport routier. A titre d'exemple, à l'heure actuelle, ce secteur représente sur le territoire de la Métropole de Lyon respectivement les deux tiers des émissions totales d'oxydes d'azote (NOₓ) et un tiers des émissions totales de particules PM10. Pourtant, à ce jour, les équipes du service Voirie Mobilité Urbaine de cette collectivité n'ont pas d'outils leur permettant de déterminer l'impact sur la qualité de l'air des aménagements routiers. Les prises de décisions en rapport avec ces sujets ne tiennent donc pas compte de l'impact sur les émissions, faute d'outils.

Plus précisément, aujourd'hui, les outils opérationnels qui permettent aux villes et aux gestionnaires de route d'estimer les émissions de polluants et de gaz à effet de serre sur les différents tronçons d'un réseau routier sont les modèles macroscopiques basés sur les facteurs d'émissions (un coefficient multiplicatif fonction de la vitesse moyenne sur le tronçon). En général, il est connu qu'à parité de vitesse moyenne, deux tronçons de route différents (par exemple un tronçon urbain en circulation fluide et un tronçon autoroutier congestionné) peuvent présenter des niveaux d'émissions très contrastés, qui seraient très mal représentés par un unique facteur d'émissions.

Par conséquent, il s'avère difficile pour les villes de prendre les bonnes décisions en matière d'aménagement de l'infrastructure routière et de législation sans avoir à disposition des outils précis d'évaluation et de projection d'impact des mesures envisagées sur les émissions polluantes du transport routier et la qualité de l'air. Ces nouveaux outils devraient idéalement permettre d'évaluer l'impact des mesures sur des échelles temporelles et spatiales très fines (de l'ordre d'une minute, et de l'ordre de dix mètres).

### Technique antérieure

La première approche visant à estimer les émissions d'un véhicule à partir de sa dynamique consiste simplement à effectuer des tests d'émissions sur banc dynamométrique. La mesure des polluants permet par exemple d'établir des matrices qui donnent un taux d'émission de polluant moyen associé à des valeurs de vitesse et d'accélération du véhicule considéré. Toutefois, les données issues de tels essais ne sont pas représentatives des conditions réelles de conduite dans la mesure où elles caractérisent essentiellement des régimes de fonctionnement stationnaires du moteur du véhicule.

Pour remédier à ce problème, des systèmes portables de mesure des émissions ont été développés depuis les années 1990 afin d'associer les émissions aux dynamiques des véhicules en conditions réelles. A partir de ces données, des modèles plus précis, dits microscopiques, peuvent être établis pour donner le taux d'émission instantané d'un véhicule en fonction de sa dynamique. Il peut par exemple s'agir de réseaux de neurones, ou de modèles de régression linéaire, comme par exemple :
- le modèle dit « Virginia Tech Microscopic energy and emissions model (VT-Micro) », de Virginia Tech, qui prend en entrée la vitesse et l'accélération du véhicule (tel que décrit dans le document Rakha, H., Ahn, K., & Trani, A. (2004). Development of VT-Micro model for estimating hot stabilized light duty vehicle and truck emissions. Transportation Research Part D: Transport and Environment, 9(1), 49-74.),
- le modèle dit « POLY », qui considère également la pente (tel que décrit dans le document Qi, Y. G., Teng, H. H., & Yu, L. (2004). Microscale emission models incorporating acceleration and deceleration. Journal of Transportation Engineering, 130(3), 348-359.), ou
- le modèle dit « Passenger car and Heavy duty Emission Model (PHEM) », de l'Université de technologie de Graz, qui est basé sur l'utilisation de cartographies avec des facteurs correctifs (tel que décrit dans le document Hausberger, S., Rodler, J., Sturm, P., & Rexeis, M. (2003). Emission factors for heavy-duty vehicles and validation by tunnel measurements. Atmospheric Environment, 37(37), 5237-5245.).

Pour aller plus loin, certains de ces modèles préalablement calibrés à partir de données expérimentales ont également été validés en conduite réelle.

Les systèmes portables de mesure des émissions conviennent pour la caractérisation de quelques véhicules spécifiques, mais pas pour des mesures à très grande échelle, notamment en raison du coût associé à leur utilisation. Une solution alternative pourrait être de mesurer indirectement les émissions du trafic à l'aide de capteurs de la qualité de l'air, mais il est difficile d'associer la pollution à sa source. Ainsi, lorsqu'il est question d'estimer les émissions de polluants d'un véhicule pour lequel ce genre de données n'est pas à disposition, une alternative consiste à les calculer en utilisant un modèle microscopique physique, qui prend de manière additionnelle en entrée les caractéristiques du véhicule en question (poids, motorisation, etc.), tel que décrit dans le document Gärtner, U., Hohenberg, G., Daudel, H., & Oelschlegel, H. (2004). Development and application of a semi-empirical NOx model to various HD diesel engines. In Thermo-and Fluid Dynamic Processes in Diesel Engines 2 (pp. 285-312). Springer, Berlin, Heidelberg, ou dans le modèle très répandu dit « Comprehensive Modal Emission Model (CMEM) » de l'Université de Californie, qui est une combinaison de modèles physiques paramétrables (tel que décrit dans le document Barth, M., An, F., Younglove, T., Scora, G., Levine, C., Ross, M., & Wenzel, T. (2000). Comprehensive Modal Emission Model (CMEM), version 2.0 user's guide. University of California, Riverside, 4.).

Ces modèles microscopiques, qu'ils soient basés sur des données ou sur un modèle physique, sont toutefois coûteux en temps de calcul et en mémoire pour les calculs et sont donc en général essentiellement conçus pour des études hors ligne. De plus, ils requièrent des profils de vitesse dynamiques précis qui ne sont en pratique que rarement mesurés. Ainsi, une autre catégorie de modèles, dits macroscopiques, a été développée pour estimer les émissions à grande échelle lorsque la complexité numérique devient trop grande, ou lorsque les trajectoires individuelles des véhicules ne sont pas à disposition. Parmi les modèles d'émissions macroscopiques, l'approche la plus répandue consiste à introduire des facteurs d'émission (FE) (tels que décrits dans les documents Ntziachristos, L., Gkatzoflias, D., Kouridis, C., & Samaras, Z. (2009). COPERT: a European road transport emission inventory model. In Information technologies in environmental engineering (pp. 491-504) et Yu, L., Xu, Y., Song, G., Hao, Y., Guo, S., & Shi, Q. (2009). Development and application of macroscopic emission model for China. Transportation research record, 2123(1), 66-75. Springer, Berlin, Heidelberg.). Les facteurs d'émission FE correspondent à des valeurs moyennes d'émissions de polluant par véhicule et par distance parcourue. Dans la plupart des cas, cette approche est basé sur des véhicules « moyens » avec un style de conduite « moyen » afin d'être représentatif du niveau d'émissions lors du passage à grande échelle. Les approches dites « COPERT » (de l'anglais « COmputer Program to calculate Emissions from Road Transports », pouvant être traduit par programme informatique de calcul des émissions des transports routiers et décrit dans le document Ntziachristos, L., Gkatzoflias, D., Kouridis, C., & Samaras, Z. (2009). COPERT: a European road transport emission inventory model. In Information technologies in environmental engineering (pp. 491-504). Springer, Berlin, Heidelberg.) et «HBEFA» (Hausberger, S. (2009). Emission Factors from the Model PHEM for the HBEFA Version 3.) sont des modèles macroscopiques très répandus basés sur des facteurs d'émission FE. Ce genre de modèles convient très bien pour la réalisation de bilans d'émissions véhiculaires à l'échelle régionale ou nationale. Il peut également permettre d'estimer de manière assez précise les émissions associées à des trajets longs. Toutefois, l'approche associée aux facteurs d'émission FE n'est par définition pas suffisamment précise lorsqu'il s'agit d'estimer les émissions réelles sur une petite échelle, car elle ne tient pas compte de l'impact de l'infrastructure locale et du style de conduite ; ainsi, leur principale cause d'erreur provient de l'impact du style de conduite et de la pente.
coûteuse en temps de calcul et en mémoire vive si l'on doit effectuer des mesures pour différentes conditions de roulements et pour plusieurs types de véhicules. De plus, son extrapolation pour un réseau routier différent ayant des infrastructures différentes va être limitée en précision. Cela est dû au fait que ces facteurs d'émissions dépendent généralement uniquement de la pente, du type de véhicule et de la vitesse moyenne.

Les demandes de brevet CN102496079 A, CN101886940 A, CN103838971A, CN104715605 A décrivent une calibration d'un modèle microscopique d'émissions. Pour cette approche, plusieurs mesures sont nécessaires pour recaler un tel modèle. Ce modèle est plus précis que celui de l'approche précédente, mais reste coûteux en temps de calcul et en temps de calibration, ainsi qu'en mémoire pour les calculs. De plus, ce modèle nécessite en entrée des vitesses dynamiques, par conséquent, cette approche reste limitée à un réseau routier pour lequel des mesures de vitesses dynamiques sont mesurées.

Les demandes de brevet CN109191793 A, CN102496079 A, IN202041007032 A, CN105206056 A, CN110232816 A décrivent un système de surveillance des émissions polluantes. Pour ce système, plusieurs capteurs sont nécessaires afin de mesurer en temps réel le flux routier mais aussi les émissions polluantes pour chaque type de véhicule. La mise en œuvre de ce système reste limitée en raison de son coût en temps de calcul.

Les demandes de brevet US 2020/355108 A1, US 2019/102960 A1, FR 3 096 822 A1 et CN 109 086 246 A décrivent des méthodes de détermination des émissions polluants d'un véhicule.

### Résumé de l'invention

La présente invention a pour but de déterminer une quantité d'émissions polluantes émises par au moins un véhicule sur un brin d'un réseau routier en prenant en compte l'impact de la congestion, de la signalisation et de la topographie du réseau routier (pente, aménagement de la voirie, etc.). Dans ce but, l'invention concerne un procédé de détermination de la quantité de polluants émis par au moins un véhicule sur un brin d'un réseau routier, dans lequel on construit, par apprentissage automatique, un modèle d'émissions polluantes au moyen de données macroscopiques d'un réseau routier d'apprentissage et de données du trafic, puis on applique ce modèle à un brin de réseau routier. La dépendance du modèle par rapport aux données macroscopiques du réseau routier et par rapport aux données de trafic permet de prendre un modèle précis à l'échelle d'un brin (échelle spatiale fine) routier et représentatif de la congestion, de la signalisation et de la topographie du réseau routier. De plus, l'application d'un tel modèle nécessite un temps de calcul réduit, et une mémoire de calcul réduite par rapport aux méthodes « microscopiques » de l'art antérieur, ce qui facilite sa mise en œuvre.

Le procédé ne nécessite pas une instrumentation spécifique de chaque véhicule, ce qui facilite également sa mise en œuvre.

L'invention concerne un procédé de détermination de la quantité d'au moins un polluant émis par au moins un véhicule sur un brin d'un réseau routier. Pour ce procédé, on met en œuvre les étapes suivantes :
a. On construit une base d'apprentissage à partir au moins de données macroscopiques d'un réseau routier d'apprentissage et de données mesurées et/ou simulées du trafic sur ledit réseau routier d'apprentissage ;
b. On construit un modèle d'émissions polluantes au moyen d'une méthode d'apprentissage automatique entrainée sur ladite base d'apprentissage construite, ledit modèle d'émissions polluantes associant à au moins un brin d'un réseau routier une quantité d'au moins un polluant émis en fonction desdites données macroscopiques dudit au moins un brin dudit réseau routier considéré et de données mesurées et/ou simulées du trafic dudit réseau routier considéré ; et
c. On détermine une quantité d'au moins un polluant émis par ledit au moins un véhicule sur ledit réseau routier considéré en appliquant ledit modèle d'émissions polluantes à des données macroscopiques dudit au moins un brin dudit réseau routier considéré et à des données mesurées et/ou simulées de trafic dudit réseau routier considéré.

Selon un mode de réalisation, on mesure lesdites données de trafic au moyen d'au moins un capteur placé sur au moins un brin du réseau routier et/ou on simule lesdites données de trafic au moyen d'une simulation de trafic, lesdites données de trafic étant de préférence le débit de véhicules et/ou la vitesse moyenne dudit au moins un véhicule pour une période prédéfinie.

Conformément à une mise en œuvre, on construit ladite base d'apprentissage au moyen en outre de données d'un parc automobile associé audit réseau routier d'apprentissage.

Selon un aspect, on détermine une quantité d'au moins un polluant émis par ledit au moins un véhicule sur ledit au moins un brin dudit réseau routier considéré au moyen en outre de données d'un parc automobile associé audit réseau routier considéré.

Conformément à un mode de réalisation, on construit ladite base d'apprentissage au moyen des étapes suivantes :
i. On détermine au moins un profil de vitesse instantanée de véhicule par mesure de la position, vitesse et altitude d'au moins un véhicule sur ledit réseau routier d'apprentissage et/ou par génération d'au moins un profil de vitesse instantanée d'au moins un véhicule ;
ii. On catégorise chaque brin dudit réseau routier d'apprentissage en fonction desdites données macroscopiques dudit réseau routier d'apprentissage ; et
iii. On construit un modèle microscopique des émissions polluantes à l'échelle d'un véhicule qui relie le profil de vitesse instantanée dudit au moins un véhicule, et la catégorie dudit au moins un brin dudit réseau routier d'apprentissage à une quantité moyenne d'au moins un polluant et un écart-type.

Avantageusement, on construit ledit modèle d'émissions polluantes par apprentissage automatique au moyen dudit modèle microscopique des émissions polluantes, de ladite catégorie des brins dudit réseau routier d'apprentissage, dudit au moins un profil de vitesse et desdites données mesurées dudit trafic.

De manière avantageuse, on génère au moins un profil de vitesse d'au moins un véhicule au moyen desdites données macroscopiques dudit réseau routier d'apprentissage et desdites données mesurées et/ou simulées du trafic au moyen d'un modèle de vitesse du véhicule construit par une méthode d'apprentissage automatique à partir desdites données mesurées et/ou simulées de trafic et desdites données macroscopiques dudit réseau routier d'apprentissage.

Selon un aspect, on détermine une quantité de polluants sur ladite au moins une portion dudit réseau routier considéré en mettant en œuvre les étapes suivantes :
i. On catégorise ledit au moins un brin dudit réseau routier considéré ;
ii. On mesure et/ou on simule ledit trafic sur au moins un brin dudit réseau routier considéré au moyen respectivement d'une boucle de comptage et/ou au moyen d'une simulation de trafic ; et
iii. On détermine une quantité d'au moins un polluant émis par ledit au moins un véhicule sur ladite au moins une portion dudit réseau routier considéré au moyen dudit modèle d'émissions polluantes en fonction de la catégorie dudit brin dudit réseau routier et de ladite mesure de trafic.

Selon une option de réalisation, ladite catégorie dudit au moins un brin est choisi parmi : un rond-point, une autoroute, un feu de circulation, un ralentisseur, une trémie, un brin sans intersection, une intersection prioritaire, une autoroute urbaine.

Selon une mise en œuvre, ledit apprentissage automatique est un apprentissage automatique supervisé, de préférence ledit apprentissage automatique est choisi parmi une régression linéaire multi-variable, un réseau de neurones, une forêt aléatoire ou une combinaison de ces méthodes.

Conformément à un mode de réalisation, ledit apprentissage automatique comprend une méthode de validation croisée, notamment une méthode de validation croisée à k blocs (« k-folds »).

Selon une caractéristique, lesdites données macroscopiques dudit réseau routier sont la topologie, et/ou la signalisation et/ou la limitation de vitesse, de préférence lesdites données macroscopiques dudit réseau routier sont fournies par un système d'information géographique.

Selon un mode de réalisation, on affiche ladite quantité d'au moins un polluant émis par l'au moins un véhicule sur ledit au moins un brin dudit réseau routier sur une carte routière, de préférence au moyen d'un téléphone intelligent ou d'un système informatique.

D'autres caractéristiques et avantages du procédé selon l'invention, apparaîtront à la lecture de la description ci-après d'exemples non limitatifs de réalisations, en se référant aux figures annexées et décrites ci-après.

### Liste des figures

La figure 1 illustre le procédé de détermination de la quantité des polluants selon un premier mode de réalisation de l'invention.
La figure 2 illustre le procédé de détermination de la quantité des polluants selon un deuxième mode de réalisation de l'invention.
Le figure 3 illustre le procédé de détermination de la quantité des polluants selon un troisième mode de réalisation de l'invention.
La figure 4 est une courbe de la quantité des polluants en fonction de la vitesse moyenne pour un exemple mettant en œuvre huit scénarii.
La figure 5 est une courbe de la quantité des polluants en fonction de la densité de trafic pour l'exemple de la figure 4.

### Description des modes de réalisation

La présente invention concerne un procédé de détermination de la quantité d'au moins un polluant d'au moins un véhicule sur au moins un brin d'un réseau routier. Ainsi, de manière générale, le procédé permet de déterminer de la quantité de polluants d'un véhicule ou d'une pluralité de véhicules qui circulent sur une portion d'un réseau routier. La quantité de polluants (également appelée quantité d'émissions polluantes) peut, par exemple, être exprimée en masse par distance, ou en concentration, ou en volume par distance. Le réseau routier est constitué de l'ensemble des routes pour un territoire donné, par exemple pour un pays ou pour une région, ou pour une ville, etc. Un brin du réseau routier est une subdivision élémentaire du réseau routier entre deux nœuds consécutifs du réseau routier. Par exemple un brin du réseau routier peut être une route entre deux intersections consécutives, entre deux signalisations consécutives, entre une intersection et une signalisation, ou une partie d'autoroute entre deux sorties consécutives, etc. Ainsi, on dispose d'un découpage fin du réseau routier, et d'un modèle qui est adapté au réseau routier sans données microscopiques. Ainsi, ce découpage permet d'obtenir une détermination des émissions polluantes la plus représentative possible à une échelle spatiale fine.

Le procédé selon l'invention peut permettre de déterminer les émissions polluantes d'au moins un des polluants (incluant les composés gazeux et/ou les particules) choisis parmi : les oxydes d'azote NOₓ, le dioxyde de carbone CO₂, le monoxyde de carbone CO, les particules fines PM, les hydrocarbures non brûlés, etc.

De préférence, le véhicule est un véhicule motorisé circulant au sein du réseau routier, tel qu'un véhicule automobile, un deux-roues, un poids lourd, un car, un bus.

Avantageusement, le procédé selon un mode de réalisation de l'invention peut déterminer la quantité de polluants pour une pluralité de véhicules se déplaçant sur le réseau routier. Ainsi, l'invention permet de mesurer la quantité de polluants pour un ensemble de véhicules, assurant ainsi une détermination de la quantité de polluants pour au moins un brin du réseau routier, de préférence sur une pluralité de brins du réseau routier.

Selon l'invention, on met en œuvre les étapes suivantes :
1. Construction d'une base d'apprentissage
2. Construction du modèle d'émissions polluantes
3. Détermination de la quantité des polluantes

Ces étapes peuvent être mises en œuvre par des moyens informatiques. Les étapes 1 et 2 peuvent être réalisées hors ligne, et l'étape 3 peut être réalisée en ligne. L'utilisation en ligne du modèle construit hors ligne permet un temps de calcul en ligne réduit, et un besoin en mémoire informatique limité, par rapport à un modèle microscopique, tout en ayant une bonne précision. Ces étapes sont détaillées dans la suite de la description.

L'invention peut être vue comme l'utilisation d'un capteur (mesure de trafic), et de moyens de traitement de signal (modèle d'émissions polluantes), pour déterminer une grandeur physique : la quantité des polluants émis.

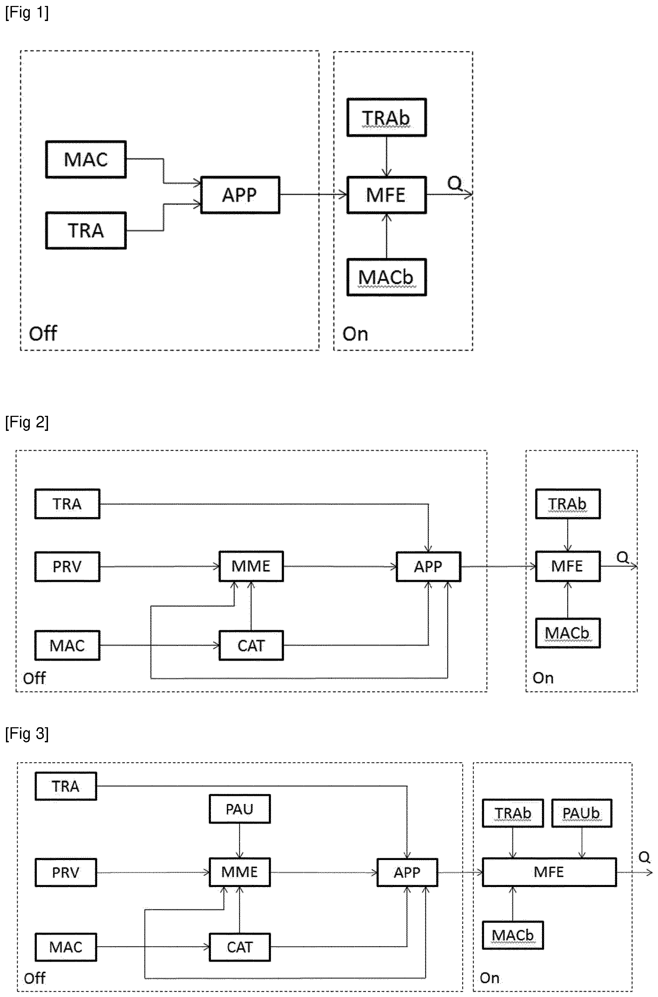

La figure 1 illustre, schématiquement et de manière non limitative, les étapes du procédé de prédiction de détermination des émissions polluantes selon un mode de réalisation de l'invention. Au moyen de données macroscopiques (MAC) d'un réseau routier d'apprentissage, et de données de trafic (TRA) du réseau routier d'apprentissage constituant une base d'apprentissage, on entraine une méthode d'apprentissage (APP) et on détermine le modèle d'émissions polluantes (MFE). Ces premières étapes sont réalisées hors ligne (Off). Ensuite, en ligne (Onl), le modèle d'émissions polluantes (MFE) permet la détermination d'une quantité des polluants (Q) pour le brin de réseau routier considéré, dont on connaît les données de trafic (TRAb) et les données macroscopiques (MACb).

### 1. Construction de la base d'apprentissage

Lors de cette étape, on construit une base d'apprentissage pour un réseau routier d'apprentissage. Le réseau routier d'apprentissage est un réseau routier pour lequel on connaît certaines caractéristiques qui servent dans l'étape 2 pour la construction du modèle des émissions polluantes. Le réseau routier d'apprentissage peut être différent ou identique du réseau routier utilisé considéré pour l'étape 3. En effet, l'invention permet de déterminer les quantités d'émissions polluantes pour un autre réseau routier que celui qu'on utilise pour construire le modèle.

On construit la base d'apprentissage à partir d'au moins de données macroscopiques d'un réseau routier d'apprentissage et à partir de données mesurées et/ou simulées du trafic sur ledit réseau routier d'apprentissage Les données macroscopiques du réseau routier correspondent aux informations liées au réseau routier, telle que l'infrastructure, la pente, la signalisation, etc. Les données de trafic sont les données mesurées ou simulées représentant le trafic sur le réseau routier.

Selon un aspect de l'invention, les données macroscopiques du réseau routier peuvent être la topologie (c'est-à-dire la pente, les virages, les intersections, la signalisation, etc.). De préférence, les données macroscopiques du réseau routier peuvent être fournies par un système d'information géographique (SIG). Here Maps ^{™}, Google Maps ^{™}, OpenStreetMap ^{™} sont des exemples de système d'information géographique. Les données macroscopiques sont toujours disponibles et depuis n'importe quel lieu. Ainsi, elles peuvent servir comme entrées uniques de la base d'apprentissage et du modèle des émissions polluantes.

De préférence, les données de trafic peuvent être choisies parmi le débit de véhicules sur ledit réseau routier et/ou la vitesse moyenne desdites véhicules pour une période prédéfinie (par exemple pour un créneau horaire, pour une journée, pour une semaine, pour un mois, etc.).

Conformément à une mise en œuvre de l'invention, on peut mesurer les données de trafic au moyen d'au moins un capteur placé sur au moins un brin du réseau routier tel qu'une boucle de comptage, une caméra, un radar, des cellules photoélectriques sensibles détectant la rupture d'un rayon lumineux, des câbles piézo-électriques mesurant la pression exercée sur la chaussée, ou tous capteurs analogues. Ces capteurs sont ponctuels ; les mesures sont donc ponctuelles, des mesures ne sont pas mises en œuvre pour tous les brins du réseau routier. De plus, on peut utiliser des données de trafic simulées au moyen d'un simulateur de trafic. Le simulateur dit « SUMO » (pour « Simulation of Urban Mobility » pouvant être traduit par simulation de mobilité urbain) est un exemple de simulateur de trafic open-source (c'est-à-dire en libre-accès). D'autres simulateurs de trafic peuvent être utilisés. Ces données simulées peuvent permettre de compléter les données mesurées, si celles-ci ne sont pas suffisantes, et ainsi améliorer la construction du modèle de facteur d'émissions polluantes.

Selon une option de réalisation, la construction de la base d'apprentissage (et par conséquent la construction du modèle des émissions polluantes) peut prendre en compte en outre le parc automobile utilisé pour le réseau routier considéré. Le parc automobile peut être le parc actuel de véhicules traversant le réseau routier considéré, en l'occurrence le réseau routier d'apprentissage. Il peut être défini par l'utilisateur en fonction des historiques d'enregistrement et/ou de la connaissance préalable du parc de véhicules de la zone considérée (c'est-à-dire le réseau routier). Ainsi, le parc prédéfini est une répartition en nombre ou en pourcentage de véhicules, de chaque véhicule prédéterminé, circulant sur la portion de réseau routier. Au sein du parc automobile, les véhicules sont catégorisés, la catégorie du véhicule peut inclure notamment une norme européenne d'émissions polluantes, une cylindrée, un type de motorisation (essence, diesel, électrique, etc.), et une technologie de post-traitement. Cette décomposition du parc automobile peut être effectuée pour les véhicules particuliers, les poids lourds, les véhicules utilitaires légers, les deux-roues, etc. Grâce à la prise en compte du parc automobile, la détermination des émissions polluantes est plus représentative des conditions réelles.

Selon un mode de réalisation de l'invention, on peut construire la base d'apprentissage, en mettant en œuvre les étapes suivantes :
1.1 Détermination d'un profil de vitesse instantanée
1.2 Catégorisation des brins du réseau routier
1.3 Construction d'un modèle microscopique des émissions polluantes.

Ces étapes peuvent être mises en œuvre par des moyens informatiques. Ces étapes sont détaillées dans la suite de la description. Les étapes 1.1 et 1.2 peuvent être réalisées dans cet ordre, en ordre inverse ou simultanément.

Pour ce mode de réalisation, les données d'apprentissage de l'apprentissage automatique peuvent comprendre la catégorie des brins du réseau routier, les données de trafic, le profil de vitesse et les émissions déterminées à partir du modèle microscopique des émissions polluantes, et le cas échéant la catégorie de véhicule (mode de réalisation pour lequel on prend en compte le parc automobile du réseau routier).

La figure 2 illustre, schématiquement et de manière non limitative, le procédé de détermination des émissions polluantes selon un mode de réalisation de l'invention. Pour ce mode de réalisation, on détermine un profil de vitesse instantanée (PRV). De plus, les données macroscopiques du réseau routier d'apprentissage (MAC) sont utilisées pour catégoriser (CAT) les brins du réseau routier. Ce profil de vitesse instantanée (PRV) et ces catégories des brins du réseau routier (CAT) permettent de construire et d'appliquer un modèle microscopique des émissions polluantes (MME). Au moyen de données macroscopiques (MAC) du réseau routier d'apprentissage, des catégories des brins du réseau routier d'apprentissage (CAT), du profil de vitesse instantanée (PRV), du modèle microscopique des émissions polluantes (MME) et de données de trafic (TRA) constituant une base d'apprentissage, on détermine le modèle d'émissions polluantes (MFE) au moyen d'un apprentissage automatique (APP). Ces premières étapes sont réalisées hors ligne (Off). Ensuite, en ligne (Onl), le modèle d'émissions polluantes (MFE) permet la détermination de la quantité des polluants (Q) pour le brin de réseau routier considéré, dont on connaît les données de trafic (TRAb) et les données macroscopiques (MACb).

### 1.1 Détermination d'un profil de vitesse instantanée

Lors de cette sous-étape, on détermine au moins un profil de vitesse instantanée de véhicule par mesure de la vitesse, de la position et de l'altitude d'au moins un véhicule sur le réseau routier d'apprentissage et/ou par génération d'au moins un profil de vitesse d'au moins un véhicule sur le réseau routier d'apprentissage. On appelle profil de vitesse, la variation de la vitesse instantanée du véhicule le long d'un brin d'un réseau routier. La prise en compte d'un profil de vitesse permet une plus grande précision du modèle, notamment par rapport à un modèle qui ne prend en compte que la vitesse moyenne sur le brin du réseau routier considéré. En effet, l'aspect dynamique du profil de vitesse permet une prise en compte notamment de l'accélération et de la décélération de l'au moins un véhicule.

De préférence, on peut déterminer au moins un profil de vitesse instantanée par mesure et on génère au moins un profil de vitesse instantanée dans le cas où le nombre de mesures serait limité. Ainsi, les profils de vitesse déterminés comprennent au moins un profil de vitesse mesuré.

De manière avantageuse, le profil de vitesse instantanée peut être un profil de vitesse à haute fréquence d'échantillonnage (minimum 1 Hz). Cette haute fréquence d'échantillonnage permet une meilleure précision du profil de vitesse et, a fortiori, une meilleure précision du modèle des émissions polluantes.

Selon un mode de réalisation de l'invention, on peut mesurer la vitesse, la position et l'altitude d'au moins un véhicule au moyen d'un téléphone intelligent, ou au moyen d'un système de géolocalisation (par exemple GPS), ou au moyen d'une instrumentation d'au moins un véhicule, ou tout moyen analogue. La mesure au moyen d'un téléphone intelligent permet une mesure à grande échelle sans instrumentation nécessaire d'une pluralité de véhicules.

Conformément à une mise en œuvre de l'invention, cette étape peut mettre en œuvre une base de données FCD (de l'anglais « floating car data » pouvant être traduit par données de trajets réalisés et mesurés). A titre d'exemple non limitatif, la base de données FCD utilisée peut contenir environ deux millions de profils de vitesse pour environ deux cent mille brins du réseau routier.

Selon un mode de réalisation, on peut générer au moins un profil de vitesse instantanée par un simulateur microscopique de trafic. Le simulateur dit « SUMO » (pour « Simulation of Urban Mobility » pouvant être traduit par simulation de mobilité urbain) est un exemple de simulateur microscopique de trafic open-source.

Alternativement ou cumulativement, on peut générer au moins un profil de vitesse instantanée d'au moins un véhicule sur le réseau routier d'apprentissage, au moyen des données macroscopiques du réseau routier d'apprentissage, et des données mesurées de trafic, au moyen d'un modèle de vitesse du véhicule construit par une méthode d'apprentissage automatique à partir des données mesurées de trafic et des données macroscopiques du réseau routier d'apprentissage.

Pour ce mode de réalisation, on peut mettre en œuvre les étapes A et B suivantes, telles que détaillées dans la demande de brevet FR 3096822 (WO2020/239503) :

### A. Construction du modèle de vitesse du véhicule

Lors de cette étape, on construit un modèle de vitesse du véhicule par une méthode d'apprentissage automatique (de l'anglais « machine learning ») entrainée à partir d'une base d'apprentissage comprenant au moins des données macroscopiques du réseau routier d'apprentissage et des données de trajets réalisés sur le réseau routier d'apprentissage. Les données de trajets réalisés permettent de prendre en compte des comportements réels afin de former un modèle de vitesse du véhicule représentatif et précis. Le modèle de vitesse du véhicule associe à au moins une subdivision du réseau routier (de préférence à un brin du réseau routier) au moins un profil de vitesse du véhicule en fonction des données macroscopiques du réseau routier et des données de trajets réalisés.

Selon un aspect de l'invention, les données de trajets réalisés peuvent comporter des données mesurées lors de trajets antérieurs, notamment la vitesse, la position et l'altitude. De préférence, les données de trajets réalisés peuvent être mesurées au moyen d'un système de géolocalisation, tel qu'un capteur de positionnement par satellite, tel que le système GPS (de l'anglais Global Positioning System), le système Galileo, etc. Le système de géolocalisation peut être embarqué à bord du véhicule ou déporté (par exemple au moyen d'un téléphone intelligent, de l'anglais « smartphone »).

Selon un mode de réalisation de l'invention, on peut construire le modèle de vitesse du véhicule en mettant en œuvre les étapes suivantes, pour le détail de ces étapes, on peut se référer à la demande de brevet FR 3096822 (WO2020/239503) :
A.1 Segmentation du réseau routier, par exemple en triplet de liaison, chaque triplet de liaison comportant un brin du réseau routier formé entre deux nœuds du réseau routier, son origine et sa destination,
A.2 Catégorisation des segments du réseau routier (la catégorisation peut être identique ou différente de la catégorisation de l'étape 1.2 décrite ci-après)
A.3 Classification des données de trajets réalisés pour chaque catégorie de segment du réseau routier
A.4 Génération d'au moins un profil de vitesse, par exemple au moyen de fonctions linéaire, parabolique ou d'une combinaison de telles fonctions, cette génération est mise en œuvre par un apprentissage automatique, par exemple une méthode de réseau de neurones, une méthode de machines à vecteur de support (de l'anglais « Support Vector Machine »), une méthode de forêts d'arbres décisionnels (de l'anglais « Random Forest ») ou d'autres méthodes d'apprentissage supervisé (ou éventuellement non supervisé), de manière avantageuse au moyen de deux réseaux de neurones en cascade.

### B. Prédiction d'au moins un profil de vitesse

Lors de cette étape, on prédit au moins un profil de la vitesse du véhicule sur la portion du réseau routier d'apprentissage. Il peut s'agir d'une portion du réseau routier d'apprentissage qui a été parcourue par les trajets antérieurs réalisés, d'une portion du réseau routier d'apprentissage qui a été partiellement parcourue par les trajets antérieurs réalisées, ou une portion du réseau routier d'apprentissage qui n'a pas été parcourue par les trajets antérieurs réalisés (il peut même s'agir d'une portion d'un réseau routier non existante, pour laquelle on souhaite prédire le profil de vitesse). Pour cette étape, on applique le modèle de vitesse du véhicule construit à l'étape A aux données macroscopiques de la portion de réseau routier considérée. Ainsi, on prend en compte les données topologiques de la portion de réseau routier considérée. Pratiquement, on attribue au moins un profil de vitesse à chaque subdivision (de préférence à chaque liaison) de la portion de réseau routier considérée.

Selon un mode de réalisation de l'invention, on peut appliquer le modèle de vitesse du véhicule en mettant en œuvre les étapes suivantes, pour le détail de ces étapes, on peut se référer à la demande de brevet FR 3096822 (WO2020/239503) :
B.1 Segmentation du brin de réseau routier, de préférence de la même manière qu'à l'étape A.1
B.2 Catégorisation du brin de réseau routier, de préférence de la même manière qu'à l'étape A.2
B.3 Attribution d'au moins un profil de vitesse à chaque brin du réseau routier considéré au moyen d'un profil de vitesse généré au moyen du modèle de vitesse du véhicule, en fonction de la catégorisation du brin de réseau routier (en d'autres termes, le segment de la portion de réseau routier considérée a un profil de vitesse identique au profil de vitesse du segment ayant la même catégorie dans le modèle de vitesse de véhicule).

Ces étapes peuvent être mises en œuvre par des moyens informatiques.

### 1.2 Catégorisation des brins du réseau routier

Lors de cette étape, on catégorise chaque brin du réseau routier d'apprentissage au moyen des données macroscopiques du réseau routier d'apprentissage. En d'autres termes, à un brin routier, on associe une catégorie qui regroupe les brins du réseau routier ayant les mêmes caractéristiques. Ainsi, afin de réduire ces temps de calcul et pour une exploitation plus large et simplifiée, on propose dans l'invention un recalage des quantités de polluants selon une décomposition fine du réseau (par type d'infrastructure, c'est-à-dire par catégorie de brin du réseau routier).

Selon un mode de réalisation, les catégories peuvent être formées à partir des critères suivants : présence ou absence de signalisation (par exemple d'un feu de signalisation), présence ou absence d'une intersection, route prioritaire ou non, importance de la courbure d'un virage, classe fonctionnelle (qui caractérise la hiérarchie du réseau routier et le niveau d'important du segment, par exemple autoroute, petite rue, etc.), nombre de voies, présence ou absence de trémie, présence ou absence d'un rond-point, etc. Ces critères sont obtenus directement des données macroscopiques du réseau routier.

De manière avantageuse et non limitative, pour limiter le nombre de catégories et pour conserver une bonne représentativité du réseau routier, les catégories des brins de réseau routier peuvent être :
- Brin avec un rond-point,
- Brin d'autoroute,
- Brin avec feu de circulation,
- Brin avec ralentisseur,
- Brin avec trémie (réduction du nombre de voies),
- Brin sans intersection,
- Brin avec intersection prioritaire,
- Brin d'autoroute urbaine.

En d'autres termes, pour cette réalisation, à chaque brin du réseau routier d'apprentissage on peut attribuer une de ces huit catégories.

### 1.3 Construction d'un modèle microscopique des émissions polluantes

Lors de cette étape, on construit un modèle microscopique, à l'échelle d'un véhicule, des émissions polluantes qui relie le profil de vitesse instantanée du véhicule, et la catégorie du brin de réseau routier à une moyenne et un écart-type des quantités de polluants émises par le véhicule sur le brin de réseau routier. En d'autres termes, le modèle microscopique permet de déterminer les émissions polluantes d'un véhicule sur un brin du réseau routier ; le modèle microscopique est dépendant du type de véhicule.

Un tel modèle est appelé microscopique car il calculent les quantités de polluants instantanées (toutes les secondes par exemple) émis par un véhicule. Selon un exemple non limitatif, le modèle microscopique utilisé dans la présente invention peut être inspiré du modèle décrit dans la demande de brevet FR 3049653 (WO 2017/174239) : il peut s'agir d'un modèle physique, modélisant la dynamique longitudinale du véhicule, le groupe motopropulseur et la chaîne électrique ou bien les systèmes de dépollution. La sortie de ce modèle, dans le cadre de la présente invention, est agrégée statistiquement pour en extraire une quantité de polluants moyen et un écart-type, et ce pour chaque polluant. En variante, le CMEM (« Comprehensive Modal Emission Model ») est un autre exemple de modèle microscopique d'émissions.

En entrée, et ce pour chaque catégorie de brin de réseau routier d'apprentissage, le modèle microscopique des émissions polluantes exploite les trajectoires dynamiques de vitesses (les profils de vitesse instantanée) ainsi que l'évolution de la pente sur le brin routier considéré appartenant à ladite catégorie. En sortie de cette étape, une quantité de polluants moyen, ainsi que l'écart type correspondant, sont définis pour chaque type d'émission (chaque type de polluant considéré), catégorie d'infrastructure, catégorie de véhicule (pour le mode de réalisation pour lequel on prendre en compte le parc automobile), débit et vitesse moyenne appartenant aux données d'apprentissage. Outre le type de véhicule, la pente, le débit ainsi que la vitesse moyenne ont un impact de premier ordre sur les émissions. L'écart type permet de prendre en compte certains comportements de conduite qui peuvent varier au sein du même brin routier ou au sein de brins routiers ayant les mêmes caractéristiques.

De préférence, le procédé peut comprendre une étape de calibrage et validation du modèle microscopique sur plusieurs mesures en roulage réel. Il permet donc de donner une estimation fiable des émissions qui prend en compte les impacts de l'infrastructure.

Selon un mode de réalisation, on peut appliquer le modèle microscopique à une pluralité de profils de vitesse dynamiques, de préférence une pluralité de profils de vitesse pour chaque caractéristique choisie parmi la vitesse moyenne, la pente et le débit de véhicules.

### 2. Construction du modèle des émissions polluantes

Lors de cette étape, on construit un modèle des émissions polluantes par une méthode d'apprentissage automatique (de l'anglais « machine learning ») entrainée au moyen de la base d'apprentissage construite tel que décrit ci-dessus, comprenant au moins de données macroscopiques du réseau routier d'apprentissage et au moyen de données de trafic sur le réseau routier. Le modèle des émissions polluantes associe à au moins un brin du réseau routier, une quantité de polluants émis par au moins un véhicule en fonction des données macroscopiques et des données de trafic. Etant donné que les données de trafic sont variables dans le temps (pour traduire par exemple les heures de congestion de début et de fin de journée, ou pour traduire le jour de la semaine, ou pour traduire le mois de l'année, etc.), le modèle des émissions polluantes ainsi construit détermine une quantité des polluants qui dépend du moment considéré, rendant la détermination des quantités de polluants précise à l'échelle temporelle considérée.

Lors de cette étape, on peut construire un modèle d'émissions polluantes par apprentissage automatique, de préférence par apprentissage automatique supervisé, au moyen de l'application du modèle microscopique construit à l'étape 1.3, pour la catégorie des brins du réseau routier, les données de trafic, le profil de vitesse, et le cas échéant le style de véhicule (parmi le parc automobile). Etant donné que l'invention proposée considérant le débit et la catégorie d'infrastructure, cela permet d'améliorer la précision des émissions même en condition de très forte congestion. De plus, l'invention propose un modèle d'émissions polluantes, simple en utilisation et qui a besoin de beaucoup moins de mesures pour être calibré et exploité.

Cette étape a pour but de construire le modèle d'émissions polluantes. Un tel modèle permet de calculer des quantités des polluants pour d'autres brins ou d'autres réseaux routiers en dehors de la base d'apprentissage. Ce modèle identifie pour chaque type d'émission et le cas échéant la catégorie de véhicule, le lien et la corrélation entre le facteur d'émission, la catégorie d'infrastructure, le débit et la vitesse moyenne. Cette identification peut s'écrire donc sous la forme : $\left[\overline{EF}, STD\right] = f \left(Cat,pente,{V}_{m},débit,EMS,veh\right)$

Avec *E̅F̅,STD* le facteur d'émission moyen et l'écart type correspondant, Cat est la catégorie du brin du réseau routier (obtenu à l'étape 1.2), pente est la pente du brin du réseau routier (obtenue depuis les données macroscopiques), Vm est la vitesse moyenne (obtenue par le profil de vitesse), débit le débit de véhicule sur le brin du réseau routier (obtenu par les données de trafic), EMS est le type d'émissions polluantes considéré (à savoir la nature du polluant émis, par exemple CO₂, NOₓ, CO, etc.), veh est la catégorie du véhicule (obtenu par le parc automobile).

La fonction f peut être basée sur un algorithme d'apprentissage supervisé, tel qu'une régression linéaire multi-variable, un réseau de neurones, une forêt aléatoire ou une combinaison de ces méthodes. A titre d'exemple non limitatif, le procédé peut mettre en œuvre un réseau de neurones avec deux couches cachées de vingt et quinze neurones respectivement, ou peut mettre en œuvre une forêt aléatoire avec vingt estimateurs (ou arbres) de profondeur égale à 15, ou tout algorithme équivalent.

Selon un aspect, cette étape peut inclure une méthode de validation, de préférence une méthode de validation croisée, notamment une méthode de validation croisée à k-blocs (« k-fold »). Cette méthode de validation croisée permet de réduire les problèmes de « surapprentissage » et d'améliorer la précision du modèle.

Le modèle d'émissions polluantes ainsi construit permet, grâce à la moyenne et à l'écart-type, une détermination précise des émissions polluantes, capable de reproduire la même variabilité statistique des émissions polluantes observables que par modèle microscopique, et pour l'ensemble des brins du réseau routier et le cas échéant pour l'ensemble des catégories de véhicule.

### 3. Détermination de la quantité des polluants

Lors de cette étape, on détermine une quantité des polluants émis par l'au moins un véhicule (de préférence par une pluralité de véhicules) sur ledit au moins un brin du réseau routier considéré, en appliquant le modèle d'émissions polluantes déterminé à l'étape 2 à des données macroscopiques du brin de réseau routier considéré et à des données mesurées de trafic. Le réseau routier considéré peut être identique ou différent du réseau routier d'apprentissage. En d'autres termes, pour le brin du réseau routier considéré, on connaît les données macroscopiques et les données de trafic, et on applique le modèle construit à l'étape précédente à ces données relatives au brin du réseau routier considéré, ce qui permet de déterminer une quantité de polluants émis par ledit véhicule pour ce brin du réseau routier.

Selon une option de réalisation, l'application du modèle des émissions polluantes peut prendre en compte en outre le parc automobile utilisé pour le réseau routier considéré. Le parc automobile considéré dans cette étape peut être différent du parc automobile considéré pour la construction du modèle des émissions polluantes : en effet le parc automobile utilisé pour les données d'apprentissage peut être différent du parc automobile du réseau routier considéré, par exemple le parc automobile peut être différent d'une région à une autre, ou peut être variable dans le temps, etc. Le parc automobile peut être le parc actuel de véhicules traversant le réseau routier considéré. Il peut être défini par l'utilisateur en fonction des historiques d'enregistrement et/ou de la connaissance préalable du parc de véhicules de la zone considérée. Ainsi, le parc prédéfini est une répartition en nombre ou en pourcentage de véhicules, de chaque véhicule prédéterminé, circulant sur la portion de réseau routier. Au sein du parc automobile, les véhicules sont catégorisés, la catégorie du véhicule peut inclure une norme européenne d'émissions polluantes, une cylindrée, un type de motorisation (essence, diesel, électrique, etc.), et une technologie de post-traitement. Cette décomposition du parc automobile peut être effectué pour les véhicules particuliers, les poids lourds, les véhicules utilitaires légers, les deux-roues, etc. Grâce à la prise en compte du parc automobile, la détermination de la quantité de polluants est plus représentative des conditions réelles.

Selon un mode de réalisation de l'invention, la détermination de la quantité de polluants peut mettre en œuvre les étapes suivantes :
2.1 Catégorisation du brin de réseau routier
2.2 Mesure du trafic sur le brin de réseau routier
2.3 Détermination de la quantité de polluants

Ces étapes peuvent être mises en œuvre par des moyens informatiques. Ces étapes sont détaillées dans la suite de la description. Les étapes 2.1 et 2.2 peuvent être mises en œuvre dans cet ordre, en ordre inverse ou de manière simultanée.

La figure 3 illustre, schématiquement et de manière non limitative, le procédé de détermination de la quantité de polluants selon un mode de réalisation de l'invention. Pour ce mode de réalisation, on détermine un profil de vitesse instantanée (PRV). De plus, les données macroscopiques du réseau routier d'apprentissage (MAC) sont utilisées pour catégoriser (CAT) les brins du réseau routier. Ce profil de vitesse instantanée (PRV) et ces catégories des brins du réseau routier d'apprentissage (CAT) ainsi qu'un parc automobile (PAU) permettent de construire et d'appliquer un modèle microscopique des émissions polluantes (MME). Au moyen de données macroscopiques (MAC) du réseau routier d'apprentissage, des catégories des brins du réseau routier (CAT), du profil de vitesse instantanée (PRV), du modèle microscopique des émissions polluantes (MME) et de données de trafic (TRA), on construit une base d'apprentissage, et on détermine le modèle d'émissions polluantes (MFE) au moyen d'un apprentissage automatique (APP). Ces premières étapes sont réalisées hors ligne (Off). Ensuite, en ligne (Onl), le modèle d'émissions polluantes (MFE) permet la détermination de la quantité des polluants (Q) pour le brin de réseau routier considéré, dont on connaît les données de trafic (TRAb) et les données macroscopiques (MACb) ainsi que le parc automobile (PAUb).

### 2.1 Catégorisation du brin du réseau routier

Lors de cette étape, on catégorise l'au moins un brin du réseau routier considéré. De préférence, on peut catégoriser tous les brins du réseau routier considéré de la même manière qu'à l'étape 1.2. Ainsi, préférentiellement, on peut catégoriser les brins du réseau routier dans les huit catégories suivantes :
- Brin avec un rond-point,
- Brin d'autoroute,
- Brin avec feu de circulation,
- Brin avec ralentisseur,
- Brin avec trémie (réduction du nombre de voies),
- Brin sans intersection,
- Brin avec intersection prioritaire,
- Brin d'autoroute urbaine.

### 2.2 Mesure des données de trafic du brin du réseau routier

Lors de cette étape, on mesure et/ou on simule le trafic sur l'au moins un brin du réseau routier considéré au moyen d'au moins un capteur placé sur au moins un brin du réseau tel qu'une boucle de comptage routier, une caméra, un radar, des cellules photoélectriques sensibles détectant la rupture d'un rayon lumineux, des câbles piézo-électriques mesurant la pression exercée sur la chaussée ou tous capteurs analogues. Ces capteurs sont ponctuels ; les mesures sont donc ponctuelles, des mesures ne sont pas mises en œuvre pour tous les brins du réseau routier. De plus, on peut utiliser des données de trafic simulées au moyen d'un simulateur de trafic. Le simulateur dit « SUMO » (pour « Simulation of Urban Mobility » pouvant être traduit par simulation de mobilité urbain) est un exemple de simulateur de trafic open-source. D'autres simulateurs de trafic peuvent être utilisés. Ces données simulées peuvent permettre de compléter les données mesurées, si celles-ci ne sont pas suffisantes, et ainsi améliorer la construction du modèle d'émissions polluantes.

### 2.3 Détermination de la quantité de polluants

Lors de cette étape, on détermine une quantité de la quantité de polluants pour chaque brin de réseau routier considérée au moyen du modèle des émissions polluantes, en fonction de la catégorisation du segment de réseau routier, des données mesurées et/ou simulées de trafic et éventuellement du parc automobile. En d'autres termes, le brin de réseau routier considéré a une quantité des émissions polluantes qui correspond au trafic, à la topologie du brin de réseau routier et éventuellement au parc automobile.

Le procédé peut comporter en outre une étape facultative d'affichage de la quantité de polluants déterminée pour au moins un brin du réseau routier considéré. Lors de cette étape facultative, on peut afficher la quantité des polluants émis sur une carte routière. Cet affichage peut prendre la forme d'une note ou d'un code couleur. Le cas échéant, une note ou une couleur peut être associée à chaque brin du réseau routier. Cet affichage peut être réalisé à bord d'un véhicule : sur le tableau de bord, sur un dispositif portatif autonome, tel qu'un appareil de géolocalisation (de type GPS), un téléphone portable (de type téléphone intelligent), ou tout système analogue. Il est également possible d'afficher la quantité des émissions polluantes sur un site internet. De plus, la quantité des polluants émis peut être partagé avec les pouvoirs publics (par exemple gestionnaire de la voirie) et les entreprises de travaux publics. Ainsi, les pouvoirs publics et les entreprises de travaux publics peuvent optimiser l'infrastructure routière pour en améliorer les émissions polluantes.

### Exemple

Les caractéristiques et avantages du procédé selon l'invention apparaîtront plus clairement à la lecture de l'exemple d'application ci-après.

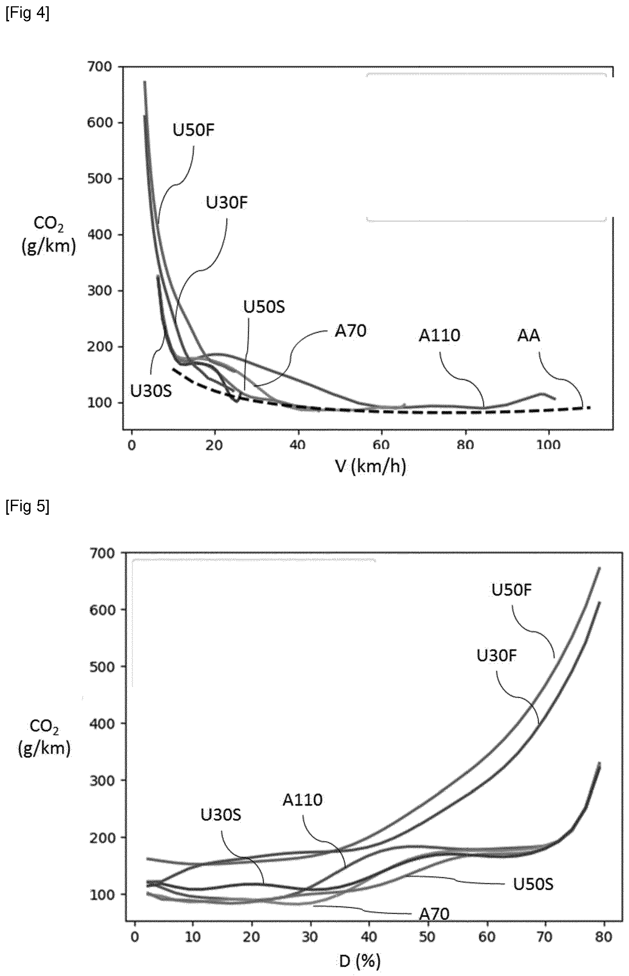

Afin d'illustrer l'invention, une série d'expériences avec le simulateur de trafic microscopique SUMO a été réalisé. L'utilisation d'un simulateur de trafic microscopique nous permet de maitriser la génération des profils de vitesse 1Hz sous différentes conditions de congestion, mais ce n'est pas strictement nécessaire à la mise en place du modèle (étape 1 du procédé selon l'invention). Pour cette simulation, la dynamique des véhicules est régie par le modèle de poursuite véhiculaire Intelligent Driver Model (IDM pouvant être traduit par modèle de conducteur intelligent). Les simulations sont réalisées sur une route circulaire de 300 mètres de long qui comprend un feu de signalisation dont la durée de cycle est 90 secondes. On définit les scénarii suivants :
- Autoroute 110 km/h : Limitation de vitesse fixée à 110 km/h, sans feu de signalisation, sur les figures 4 et 5 ce scénario est indiqué A110.
- Autoroute 70 km/h : Limitation de vitesse fixée à 70 km/h, sans feu de signalisation, sur les figures 4 et 5 ce scénario est indiqué A70.
- Route urbaine 50 km/h (sans feu) : Limitation de vitesse fixée à 50 km/h, sans feu de signalisation, sur les figures 4 et 5, ce scénario est indiqué U50S.
- Route urbaine 30 km/h (sans feu) : Limitation de vitesse fixée à 30 km/h, sans feu de signalisation, sur les figures 4 et 5, ce scénario est indiqué U30S.
- Route urbaine 50 km/h (avec feu) : Limitation de vitesse fixée à 50 km/h, avec feu de signalisation, sur les figures 4 et 5, ce scénario est indiqué U50F.
- Route urbaine 30 km/h (avec feu) : Limitation de vitesse fixée à 30 km/h, avec feu de signalisation, sur les figures 4 et 5, ce scénario est indiqué U30F.

Pour chaque scénario, différentes simulations sont réalisées avec une densité de véhicules sur l'anneau qui varie de 0% à 80% de la densité maximum de la structure. Chaque simulation dure 1 heure. A l'issue de chaque expérience, les émissions de CO₂ des véhicules sont calculées à partir de leurs profils de vitesse, en utilisant un modèle de consommation énergétique microscopique physique (étape 1.3 de l'invention). Pour cet exemple, des véhicules légers de type Euro 4 diesel sont simulés.

Les trajectoires des véhicules fournissent également des informations sur la vitesse moyenne du trafic ainsi que la distance parcourue par les véhicules. En ramenant les émissions à la distance parcourue, chaque expérience peut être associée à un taux d'émissions de CO₂ par exemple, exprimé en g/km.

La Figure 4 représente pour chaque scénario le taux d'émissions de CO₂ en g/km en fonction de la vitesse moyenne du trafic V en km/h. De manière non limitative, les taux d'émissions ont été approximés par des régressions polynomiales dans cet exemple. Elles sont comparées au calcul d'émissions réalisé avec la méthode de type facteur d'émissions macroscopique COPERT (état de l'art noté AA), ne prenant en entrée que la vitesse moyenne du trafic. On peut noter que cette approche de l'état de l'art considère en entrée une valeur minimum de 10 km/h, ce qui mène à une mauvaise caractérisation des émissions à très forte congestion et donc à très faible vitesse moyenne. Au contraire, l'invention permet une caractérisation des émissions polluantes même en cas de forte congestion et à faible vitesse moyenne. Sur les scénarii considérés, on peut constater que l'approche « facteur d'émissions » de l'état de l'art donne en général une bonne approximation des émissions polluantes pour d'importantes vitesses moyennes. Toutefois, cette approche de l'art antérieur est susceptible de grandement sous-estimer les émissions polluantes à plus faible vitesse moyenne, car elle ne prend pas en compte le type d'infrastructure et l'impact de la congestion. Ainsi, les scénarii urbains avec feux de signalisation présentent par exemple des niveaux d'émissions calculés avec l'invention bien supérieurs à ceux donnés par la méthode de l'état de l'art basée sur les facteurs d'émissions.

Les résultats de cette série d'expériences peuvent être illustrés avec une autre perspective afin notamment de pouvoir associer une densité à une valeur de vitesse moyenne. Ainsi, la Figure 5 présente l'évolution des taux d'émissions de CO₂ en g/km en fonction de la densité de véhicules D en % pour ces scénarii. Pour cet exemple, on constate que c'est en régime très congestionné que les émissions peuvent le plus différer de la sortie du modèle basé sur les facteurs d'émissions de l'art antérieur. Au contraire, l'invention permet de mieux considérer ces situations grâce à la prise en compte du trafic routier.

## Revendications

1. Procédé de détermination de la quantité (Q) d'au moins **un** polluant émis par au moins un véhicule sur un brin d'un réseau routier, **caractérisé en ce qu'**on met en œuvre les étapes suivantes :
a. On construit une base d'apprentissage à partir au moins de données macroscopiques (MAC) d'un réseau routier d'apprentissage et de données mesurées et/ou simulées du trafic (TRA) sur ledit réseau routier d'apprentissage, lesdites données mesurées étant obtenues au moyen d'un capteur placé sur au moins un brin du réseau routier, et lesdites données simulées étant obtenues au moyen d'une simulation de trafic ; lesdites données du trafic étant le débit de véhicules et/ou la vitesse moyenne dudit au moins un véhicule pour une période prédéfinie ;
b. On construit un modèle d'émissions polluantes (MFE) au moyen d'une méthode d'apprentissage automatique (APP) entraînée sur ladite base d'apprentissage construite, ledit modèle d'émissions polluantes associant audit au moins un brin dudit réseau routier une quantité d'au moins un polluant émis en fonction desdites données macroscopiques dudit au moins un brin dudit réseau routier considéré et de données mesurées et/ou simulées du trafic dudit réseau routier considéré ; et
c. On détermine une quantité (Q) d'au moins un polluant émis par ledit au moins un véhicule sur ledit réseau routier considéré en appliquant ledit modèle d'émissions polluantes (MFE) à des données macroscopiques (MACb) dudit au moins un brin dudit réseau routier considéré et à des données mesurées et/ou simulées de trafic (TRAb) dudit réseau routier considéré.

2. Procédé selon la revendication 1, dans lequel on construit ladite base d'apprentissage au moyen en outre de données d'un parc automobile (PAU) associé audit réseau routier d'apprentissage.

3. Procédé selon l'une des revendications précédentes, dans lequel on détermine une quantité d'au moins un polluant émis par ledit au moins un véhicule sur ledit au moins un brin dudit réseau routier considéré au moyen en outre de données d'un parc automobile (PAUb) associé audit réseau routier considéré.

4. Procédé selon l'une des revendications précédentes, dans lequel on construit ladite base d'apprentissage au moyen des étapes suivantes :
i. On détermine au moins un profil de vitesse (PRV) instantanée de véhicule par mesure de la position, vitesse et altitude d'au moins un véhicule sur ledit réseau routier d'apprentissage et/ou par génération d'au moins un profil de vitesse instantanée d'au moins un véhicule ;
ii. On catégorise (CAT) chaque brin dudit réseau routier d'apprentissage en fonction desdites données macroscopiques dudit réseau routier d'apprentissage ; et
iii. On construit un modèle microscopique des émissions polluantes (MME) à l'échelle d'un véhicule qui relie le profil de vitesse instantanée (PRV) dudit au moins un véhicule, et la catégorie (CAT) dudit au moins un brin dudit réseau routier d'apprentissage à une quantité moyenne d'au moins un polluant et un écart-type.

5. Procédé selon la revendication 4, dans lequel on construit ledit modèle d'émissions polluantes (MFE) par apprentissage automatique au moyen dudit modèle microscopique (MME) des émissions polluantes, de ladite catégorie (CAT) des brins dudit réseau routier d'apprentissage, dudit au moins un profil de vitesse (PRV) et desdites données mesurées dudit trafic (TRA).

6. Procédé selon la revendication 4 ou 5, dans lequel on génère au moins un profil de vitesse (PRV) d'au moins un véhicule au moyen desdites données macroscopiques (MAC) dudit réseau routier d'apprentissage et desdites données mesurées et/ou simulées du trafic (TRA) au moyen d'un modèle de vitesse du véhicule construit par une méthode d'apprentissage automatique à partir desdites données mesurées et/ou simulées de trafic (TRA) et desdites données macroscopiques (MAC) dudit réseau routier d'apprentissage.

7. Procédé selon l'une des revendications 4 à 6, dans lequel on détermine une quantité de polluants sur ladite au moins une portion dudit réseau routier considéré en mettant en œuvre les étapes suivantes :
i. On catégorise ledit au moins un brin dudit réseau routier considéré ;
ii. On mesure et/ou on simule ledit trafic (TRAb) sur au moins un brin dudit réseau routier considéré au moyen respectivement d'une boucle de comptage et/ou au moyen d'une simulation de trafic ; et
iii. On détermine une quantité (Q) d'au moins un polluant émis par ledit au moins un véhicule sur ladite au moins une portion dudit réseau routier considéré au moyen dudit modèle d'émissions polluantes en fonction de la catégorie dudit brin dudit réseau routier et de ladite mesure de trafic (TRAb).

8. Procédé selon l'une des revendications 4 à 7, dans lequel ladite catégorie dudit au moins un brin est choisi parmi : un rond-point, une autoroute, un feu de circulation, un ralentisseur, une trémie, un brin sans intersection, une intersection prioritaire, une autoroute urbaine.

9. Procédé selon l'une des revendications précédentes, dans lequel ledit apprentissage automatique est un apprentissage automatique supervisé, de préférence ledit apprentissage automatique est choisi parmi une régression linéaire multi-variable, un réseau de neurones, une forêt aléatoire ou une combinaison de ces méthodes.

10. Procédé selon l'une des revendications précédentes, dans lequel ledit apprentissage automatique comprend une méthode de validation croisée, notamment une méthode de validation croisée à k blocs (« k-folds »).

11. Procédé selon l'une des revendications précédentes, dans lequel lesdites données macroscopiques (MAC, MACb) dudit réseau routier sont la topologie, et/ou la signalisation et/ou la limitation de vitesse, de préférence lesdites données macroscopiques dudit réseau routier sont fournies par un système d'information géographique.

12. Procédé selon l'une des revendications précédentes, dans lequel on affiche ladite quantité (Q) d'au moins un polluant émis par l'au moins un véhicule sur ledit au moins un brin dudit réseau routier sur une carte routière, de préférence au moyen d'un téléphone intelligent ou d'un système informatique.

## Patentansprüche

1. Verfahren zur Bestimmung der Menge (Q) mindestens eines Schadstoffs, der von mindestens einem Fahrzeug auf einem Abschnitt eines Straßennetzes emittiert wird, **dadurch gekennzeichnet, dass** die folgenden Schritte durchgeführt werden:
a. Aufbauen einer Lerndatenbank ausgehend von mindestens makroskopischen Daten (MAC) eines Lernstraßennetzes und von gemessenen und/oder simulierten Daten des Verkehrs (TRA) auf dem Lernstraßennetz, wobei die gemessenen Daten mittels eines Sensors erhalten werden, der auf mindestens einem Abschnitt des Straßennetzes positioniert ist, und wobei die simulierten Daten mittels einer Verkehrssimulation erhalten werden; wobei die Daten des Verkehrs der Fahrzeugdurchsatz und/oder die Durchschnittsgeschwindigkeit des mindestens einen Fahrzeugs für einen vordefinierten Zeitraum sind;
b. Aufbauen eines Schadstoffemissionsmodells (MFE) mittels einer auf der aufgebauten Lerndatenbank trainierten Methode des maschinellen Lernens (APP), wobei das Schadstoffemissionsmodell mindestens einem Abschnitt eines Straßennetzes eine Menge mindestens eines emittierten Schadstoffs in Abhängigkeit von den makroskopischen Daten des mindestens einen Abschnitts des betrachteten Straßennetzes und von gemessenen und/oder simulierten Daten des Verkehrs des betrachteten Straßennetzes zuordnet; und
c. Bestimmen einer Menge (Q) mindestens eines Schadstoffs, der von dem mindestens einem Fahrzeug auf dem betrachteten Straßennetz emittiert wird, indem das Schadstoffemissionsmodell (MFE) auf makroskopische Daten (MACb) des mindestens einen Abschnitts des betrachteten Straßennetzes und auf gemessene und/oder simulierte Verkehrsdaten (TRAb) des betrachteten Straßennetzes angewandt wird.

2. Verfahren nach Anspruch 1, wobei die Lerndatenbank ferner mittels Daten einer Fahrzeugflotte (PAU), die dem Lernstraßennetz zugeordnet ist, aufgebaut wird.

3. Verfahren nach einem der vorhergehenden Ansprüche, wobei eine Menge mindestens eines Schadstoffs, der von dem mindestens einen Fahrzeug auf dem mindestens einen Abschnitt des betrachteten Straßennetzes emittiert wird, ferner mittels Daten einer Fahrzeugflotte (PAUb), die dem betrachteten Straßennetz zugeordnet ist, bestimmt wird.

4. Verfahren nach einem der vorhergehenden Ansprüche, wobei die Lerndatenbank mittels der folgenden Schritte aufgebaut wird:
i. Bestimmen mindestens eines Momentangeschwindigkeitsprofils (PRV) eines Fahrzeugs durch Messen der Position, Geschwindigkeit und Höhe mindestens eines Fahrzeugs auf dem Lernstraßennetz und/oder durch Erzeugen mindestens eines Momentangeschwindigkeitsprofils mindestens eines Fahrzeugs;
ii. Kategorisieren (CAT) jedes Abschnitts des Lernstraßennetzes in Abhängigkeit von den makroskopischen Daten des Lernstraßennetzes; und
iii. Aufbauen eines mikroskopischen Modells der Schadstoffemissionen (MME) auf Ebene eines Fahrzeugs, welches das Momentangeschwindigkeitsprofil (PRV) des mindestens eines Fahrzeugs und die Kategorie (CAT) des mindestens einen Abschnitts des Lernstraßennetzes mit einer durchschnittlichen Menge mindestens eines Schadstoffs und einer Standardabweichung verknüpft.

5. Verfahren nach Anspruch 4, wobei das Schadstoffemissionsmodell (MFE) durch maschinelles Lernen mittels des mikroskopischen Modells (MME) der Schadstoffemissionen, der Kategorie (CAT) der Abschnitte des Lernstraßennetzes, des mindestens einen Geschwindigkeitsprofils (PRV) und der gemessenen Daten des Verkehrs (TRA) aufgebaut wird.

6. Verfahren nach Anspruch 4 oder 5, wobei mindestens ein Geschwindigkeitsprofil (PRV) mindestens eines Fahrzeugs mittels der makroskopischen Daten (MAC) des Lernstraßennetzes und der gemessenen und/oder simulierten Daten des Verkehrs (TRA) mittels eines Geschwindigkeitsmodells des Fahrzeugs erzeugt wird, das mit einer Methode des maschinellen Lernens ausgehend von den gemessenen und/oder simulierten Verkehrsdaten (TRA) und von den makroskopischen Daten (MAC) des Lernstraßennetzes aufgebaut wurde.

7. Verfahren nach einem der Ansprüche 4 bis 6, wobei eine Schadstoffmenge auf dem mindestens einen Teilabschnitt des betrachteten Straßennetzes bestimmt wird, indem die folgenden Schritte durchgeführt werden:
i. Kategorisieren des mindestens einen Abschnitts des betrachteten Straßennetzes;
ii. Messen und/oder Simulieren des Verkehrs (TRAb) auf mindestens einem Abschnitt des betrachteten Straßennetzes mittels einer Zählschleife oder mittels einer Verkehrssimulation; und
iii. Bestimmen einer Menge (Q) mindestens eines Schadstoffs, der von dem mindestens einen Fahrzeug auf dem mindestens einen Teilabschnitt des betrachteten Straßennetzes emittiert wird, mittels des Schadstoffemissionsmodells in Abhängigkeit von der Kategorie des Abschnitts des Straßennetzes und von der Verkehrsmessung (TRAb).

8. Verfahren nach einem der Ansprüche 4 bis 7, wobei die Kategorie des mindestens einen Abschnitts ausgewählt ist aus: einem Kreisverkehr, einer Autobahn, einer Ampel, einer Fahrbahnschwelle, einer Unterführung, einem Abschnitt ohne Kreuzung, einer Kreuzung mit Vorfahrt, einer Stadtautobahn.

9. Verfahren nach einem der vorhergehenden Ansprüche, wobei das maschinelle Lernen ein überwachtes maschinelles Lernen ist, wobei das maschinelle Lernen vorzugsweise aus einer multivariaten linearen Regression, einem neuronalen Netzwerk, einem Random Forest oder einer Kombination dieser Methoden ausgewählt ist.

10. Verfahren nach einem der vorhergehenden Ansprüche, wobei das maschinelle Lernen eine Kreuzvalidierungsmethode, insbesondere eine K-Fold-Kreuzvalidierungsmethode umfasst.

11. Verfahren nach einem der vorhergehenden Ansprüche, wobei die makroskopischen Daten (MAC, MACb) des Straßennetzes die Topologie und/oder die Beschilderung und/oder die Geschwindigkeitsbegrenzung sind, wobei die makroskopischen Daten des Straßennetzes vorzugsweise von einem geografischen Informationssystem bereitgestellt werden.

12. Verfahren nach einem der vorhergehenden Ansprüche, wobei die Menge (Q) mindestens eines Schadstoffs, der von dem mindestens einen Fahrzeug auf dem mindestens einen Abschnitt des Straßennetzes emittiert wird, auf einer Straßenkarte, vorzugsweise mittels eines Smartphones oder eines Computersystems, angezeigt wird.

## Claims

1. Method for determining the amount (Q) of at least one pollutant emitted by at least one vehicle on a stretch of a road network, **characterized in that** the following steps are implemented:
a. a training database is constructed using at least macroscopic data (MAC) regarding a training road network and measured and/or simulated traffic data (TRA) regarding traffic on said training road network, said measured data being obtained by means of a sensor placed on at least one stretch of the road network, and said simulated data being obtained by means of a traffic simulation, said traffic data being traffic flow and/or the average speed of said at least one vehicle over a predefined period;
b. a model of polluting emissions (MFE) is constructed by means of a machine-learning method (APP) trained on said constructed training database, said model of polluting emissions associating with at least one stretch of a road network an amount of at least one pollutant emitted depending on said macroscopic data regarding said at least one stretch of said road network in question and on measured and/or simulated traffic data regarding traffic on said road network in question; and
c. an amount (Q) of at least one pollutant emitted by said at least one vehicle on said road network in question is determined by applying said model of polluting emissions (MFE) to macroscopic data (MACb) regarding said at least one stretch of said road network in question and to measured and/or simulated traffic data (TRAb) regarding traffic on said road network in question.

2. Method according to Claim 1, wherein said training database is further constructed by means of data (PAU) regarding a vehicle fleet associated with said training road network.

3. Method according to either of the preceding claims, wherein an amount of at least one pollutant emitted by said at least one vehicle on said at least one stretch of said road network in question is further determined by means of data (PAUb) regarding a vehicle fleet associated with said road network in question.

4. Method according to any of the preceding claims, wherein said training database is constructed by means of the following steps:
i. at least one instantaneous vehicle speed profile (PRV) is determined by measuring the position, speed and altitude of at least one vehicle on said training road network and/or by generating at least one instantaneous speed profile of at least one vehicle;
ii. each stretch of said training road network is categorized (CAT) depending on said macroscopic data of said training road network; and
iii. a microscopic model of polluting emissions (MME) at the scale of one vehicle is constructed, which model relates the instantaneous speed profile (PRV) of said at least one vehicle and the category (CAT) of said at least one stretch of said training road network to an average amount of at least one pollutant and to a standard deviation.

5. Method according to Claim 4, wherein said model of polluting emissions (MFE) is constructed by machine learning by means of said microscopic model of polluting emissions (MME), of said category (CAT) of the stretches of said training road network, of said at least one speed profile (PRV) and of said measured data of said traffic (TRA).

6. Method according to Claim 4 or 5, wherein at least one speed profile (PRV) of at least one vehicle is generated by means of said macroscopic data (MAC) of said training road network and of said measured and/or simulated traffic data (TRA) by means of a vehicle speed model constructed using a machine-learning method from said measured and/or simulated traffic data (TRA) and said macroscopic data (MAC) of said training road network.

7. Method according to any of Claims 4 to 6, wherein an amount of pollutants on said at least one segment of said road network in question is determined by implementing the following steps:
i. said at least one stretch of said road network in question is categorized;
ii. said traffic (TRAb) on at least one stretch of said road network in question is measured and/or simulated by means of a loop detector and/or by means of traffic simulation, respectively; and
iii. an amount (Q) of at least one pollutant emitted by said at least one vehicle on said at least one segment of said road network in question is determined by means of said model of polluting emissions depending on the category of said stretch of said road network and on said measurement of traffic (TRAb).

8. Method according to any of Claims 4 to 7, wherein said category of said at least one stretch is selected from: a roundabout, a motorway, a traffic light, a speed bump, a grade-separated underpass, a stretch without intersection, a right-of-way intersection, an urban motorway.

9. Method according to any of the preceding claims, wherein said machine learning is supervised machine learning, said machine learning preferably being selected from a multiple linear regression, a neural network, a random forest or a combination of these methods.

10. Method according to any of the preceding claims, wherein said machine learning comprises a cross-validation method, especially a k-fold cross-validation method.

11. Method according to any of the preceding claims, wherein said macroscopic data (MAC, MACb) regarding said road network are topology, and/or signalling and/or speed limit, said macroscopic data regarding said road network preferably being provided by a geographic information system.

12. Method according to any of the preceding claims, wherein said amount (Q) of at least one pollutant emitted by the at least one vehicle on said at least one stretch of said road network is displayed on a road map, preferably by means of a smart phone or an information-technology system.
